Europäisches Patentamt

European Patent Office

Office européen des brevets

(11) Publication number: **0 216 581**
**A2**

(12) **EUROPEAN PATENT APPLICATION**

(21) Application number: 86307033.0

(22) Date of filing: 12.09.86

(51) Int. Cl.⁴: **H 01 L 21/60**

(30) Priority: 21.09.85 GB 8523373

(43) Date of publication of application:
01.04.87 Bulletin 87/14

(84) Designated Contracting States:
BE DE FR IT NL

(71) Applicant: STC plc
10, Maltravers Street
London, WC2R 3HA(GB)

(72) Inventor: Baker, Roger Leslie
7, Third Avenue
Chelmsford Essex(GB)

(72) Inventor: Jennings, Stephen Robert
8, Shangari Road
Bishop's Stortford Hertfordshire(GB)

(72) Inventor: Albin, Sacharia
164, Lancelot Road
Wembley Middlesex(GB)

(54) Via profiling in integrated circuits.

(57) Vias are formed in multilayer integrated circuits by etching of an uncured or partially cured dielectric film prior to etching to define the via. Heating of the partially cured dielectric produces flow prior to final curing. This provides a smooth edge to the via thus reducing the risk of discontinuity in an upper metallisation layer.

EP 0 216 581 A2

Croydon Printing Company Ltd.

R.L. Baker - S.R. Jennings 0216581
S. Albin 11-2-1

VIA PROFILING IN INTEGRATED CIRCUITS

This invention relates to integrated circuits, and in particular to methods of forming vias in such circuits.

With the ever increasing complexity of integrated circuits, two or more layers of interconnect are frequently required. One of the most important stages in the production of multi-layer metal circuits is that of via patterning. In a conventional process a dielectric film of about 1 micron thickness is deposited and a high temperature anneal is performed to give the dielectric its optimal electrical properties. Then a multi-stage etch process is used to produce a tapered via. The disadvantage of this approach is that it is critically dependent on etch uniformity and reproducibility. It also requires the use of complex multi-stage etching normally needing more than one plasma etch.

An approach to this problem is described in European patent application No. 80302569.1 (specification No. 0026967). This describes a process in which a metal track is first coated with a glass and a window is then etched through the the track. A polyimide layer is then applied and a second etch is performed to reopen the windows. The configuration of the underlying glass gives the polyimide a relatively smooth profile thus providing the necessary taper cross-section. It will be appreciated, however, that this process requires two masks and two etching stages and is thus relatively time consuming.

The object of the present invention is to minimise or to overcome this disadvantage.

According to the invention there is provided a method of fabricating a via in an integrated circuit, the method including depositing a curable dielectric film over a conductor track, heating the dielectric to effect a partial cure, anisotropically etching the partially cured dielectric to define the via and expose the track, and further heating the dielectric thereby flowing the dielectric to form a smoothly profiled cross-section adjacent the via and effecting curing of the dielectric.

The dielectric is partially cured before etching to define the via. By suitable choice of the curing conditions a desired tapered profile may be obtained.

An embodiment of the invention will now be described with reference to the accompanying drawings in which:

Figs. 1 to 3 illustrate successive stages in via formation;

and Fig. 4 illustrates the relationship between via profile and the part-cure temperature.

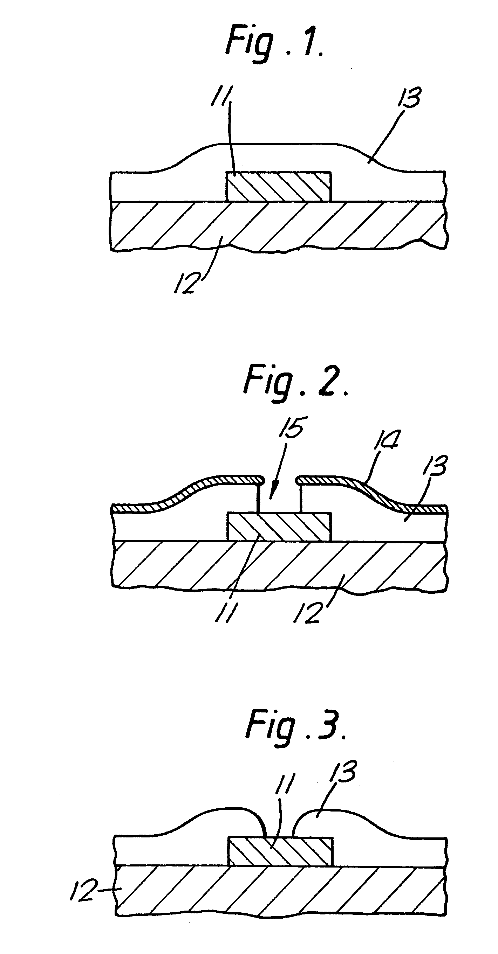

Referring to Figs. 1 to 3, a metallisation track 11, e.g. of aluminium, is provided on a semiconductor substrate 12. The track and surrounding substrate are coated with a dielectric film 13, typically 0.5 to 2 microns thickness, which film is heated to affect partial curing. Typically we employ a polyimide which is maintained at a temperature of $115^{\circ}$C to $200^{\circ}$C for a period of 10 to 60 minutes, but it will be clear that the conditions for effecting a partial cure will depend on the particular polymer that is employed. Preferably the part-cure temperature is from $125^{\circ}$C to $150^{\circ}$C.

Where a polyimide dielectric is employed, the result of this partial cure is to effect imidisation to form the polymer. This reaction, which at $200^{\circ}$

0216581

provides about 98% imidisation, releases water. The material at this stage is rigid and self supporting but contains moisture from the polymerisation reaction.

A patterned mask 14 is provided on the film 13. This mask, which may be either erodable, e.g. a photoresist, or non-erodable, e.g. titanium, is then used to selectively etch the dielectric film 13 to expose the underlying metal 11 and to define the via 15. This etching stage may be effected by anisotropic etching e.g. with an oxygen plasma.

The mask 14 is then removed (Fig. 3) and the dielectric adjacent the via is profiled by annealing the partly cured dielectric to complete the cure. During the early stages of this anneal the dielectric flows to provide a smooth edge to the via. This facilitates the application of a further metallisation level (not shown) as the absence of a sharp step at the via edge minimises the risk of discontinuities in this upper metal layer. Typically this final cure comprises a ramp heating stage from $150^{\circ}$C to $420^{\circ}$C at a rate of $10^{\circ}$C per minute followed by 10 to 30 minutes at $420^{\circ}$C.

During the second heating stage the imidisation reaction is driven to completion and the trapped moisture from the previous heating stage is driven off, thus providing a fully cured material.

It will be appreciated that only one mask and one etch are required. This provides a considerable processing advantage over conventional techniques.

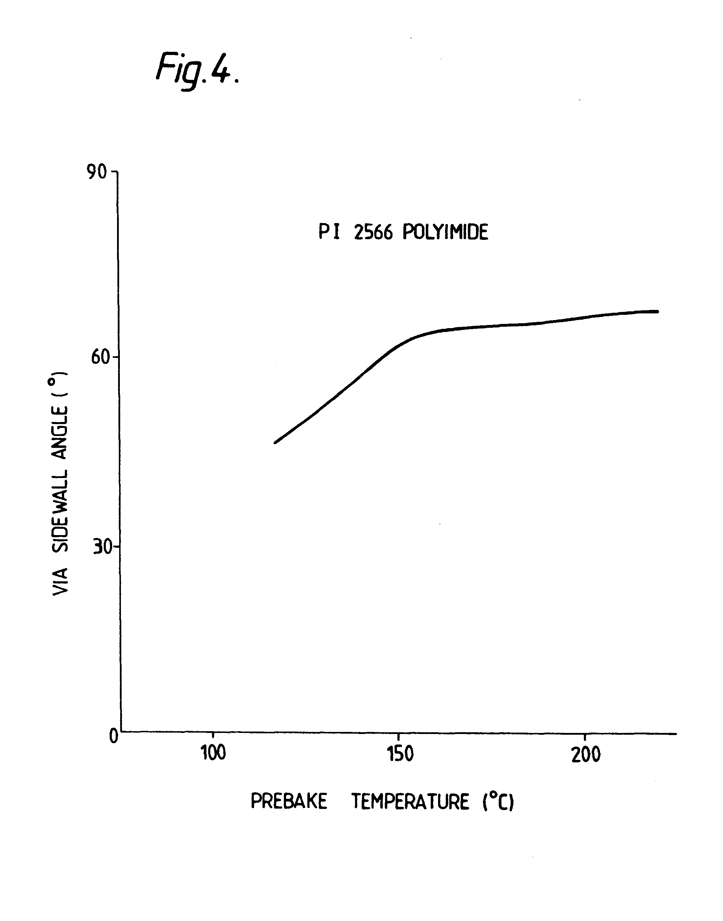

The profile of the finished via is a function of the temperature of the first part cure stage. This effect is illustrated in Fig. 4 which shows the relationship between via side-wall angle and part cure or prebake temperature. As can be seen from Fig. 4, a prebake temperature below $150^{\circ}$ provides a sidewall angle of about $60^{\circ}$ or less. This contrasts with the conventional process which provides sidewall angles of about $70^{\circ}$.

We have fabricated contact chains using both a conventional process and the processes described herein and compared the via resistances. The two stage cure has shown no adverse effect on the via resistance obtained between two layers of metallisation. High yields on 3 micron and 2 micron via chains have been produced using this process. Typical via resistances of 75m$\Omega$ per via for a 3 micron contact chain and 98m$\Omega$ per via for a 2 micron contact chain were measured. Metal step coverage was improved and step resistance was reduced compared to the standard 'non-flowed' process. By use of this technique the via etching requirements are considerably relaxed and hence higher yields can be obtained. In a further example, via chains of 2400 vias of 2 micron and 3 micron widths were prepared using the process described herein and, for comparison, a conventional process. The results of via average resistance measurements are summarised below.

Conventional Process

| | |
|---|---|
| 3 micron | 65 milliohm per via |
| 2 micron | 86 milliohm per via |

Current Process

| | |
|---|---|
| 3 micron | 47 milliohm per via |
| 2 micron | 68 milliohm per via |

These results demonstrate the feasibility of the current process described above.

Whilst the use of a polyimide as the dielectric material will in general necessitate a partial cure before etching, it will be appreciated that other polymers may be employed which, in the uncured state, are sufficiently self supporting to obviate the need for the partial curing stage.

The preferred dielectric is a polyimide PI 2566 sold by Du Pont. This material has a low glass transition temperature and is particularly suited to the above process.

CLAIMS:-

1.       A method of fabricating a via in an integrated circuit, the method including depositing a curable dielectric film over a conductor track, heating the dielectric to effect a partial cure, anisotropically etching the partially cured dielectric to define the via and expose the track, and further heating the dielectric thereby flowing the dielectric to form a smoothly profiled cross-section adjacent the via and effecting curing of the dielectric.

2.       A method of fabricating a via in an integrated circuit, the method including depositing a dielectric film curable via a condensation polymerisation over a conductor track, partially curing the dielectric by heating the dielectric to a temperature sufficient to effect polymerisation but insufficient to remove the reaction byproducts, anisotropically etching the partially cured dielectric to define the via and expose the track, and annealing the dielectric thereby flowing the dielectric to form a smoothly profiled cross-section adjacent the via and completing the cure.

3.       A method as claimed in claim 2, characterised in that the dielectric is a polyimide.

4.       A method as claimed in claim 3, characterised in that the dielectric is partially cured by heating to a temperature of 115 to 200$^{\circ}$C for a period of 10 to 60 minutes.

5.       A method as claimed in any one of claims 1 to 4, characterised in that the dielectric is etched with an oxygen plasma.

6.       A method as claimed in any one of claims 1 to 6, characterised in that the dielectric is annealed by heating at a steadily increasing rate to a maximum annealing temperature.

7.       An integrated circuit incorporating vias formed by a method as claimed in any one of claims 1 to 6.

112

Fig.1.

Fig.2.

Fig.3.

*Fig.4.*

PI 2566 POLYIMIDE

VIA SIDEWALL ANGLE (°)

PREBAKE TEMPERATURE (°C)